# DEMANDE DE BREVET EUROPEEN

(11) **EP 0 948 045 A1**
(43) Date de publication de la demande: **06.10.1999**
(21) Numéro de dépôt: 99410026.1
(22) Date de dépôt: 30.03.1999
(51) Int. Cl.: H01L 21/8247

(54) **Procédé de fabrication d'un point mémoire en technologie bicmos**

(30) Priorité: 31.03.1998 FR 9804209
(71) Demandeur: STMicroelectronics SA, 94250 Gentilly (FR); FRANCE TELECOM, 75015 Paris (FR)
(72) Inventeur: Laurens, Michel, 38120 Saint Egréve (FR)
(74) Mandataire: de Beaumont, Michel

(57) **Abrégé**

L'invention concerne un procédé de fabrication d'un transistor MOS, comprenant les étapes consistant à délimiter au moyen d'un premier masque de résine des zones d'implantation de drain (24) et de source (25) de type N ; éliminer le premier masque et faire diffuser le dopant implanté ; recuire, d'où il résulte qu'il se forme un oxyde plus épais (28, 29) au-dessus des régions de source et de drain qu'au-dessus de la partie centrale d'isolement de grille (27) ; former un doigt de silicium polycristallin au-dessus de la partie centrale d'isolement de grille (27) de façon à constituer la grille (30) du transistor MOS ; et procéder à une deuxième implantation de source/drain (34, 35).

## Description

La présente invention concerne un procédé de fabrication d'un transistor MOS et plus particulièrement d'un transistor MOS faisant partie d'un point mémoire.

La présente invention s'applique notamment à la fabrication de points mémoire compatible avec des procédés de fabrication classiques de transistors CMOS.

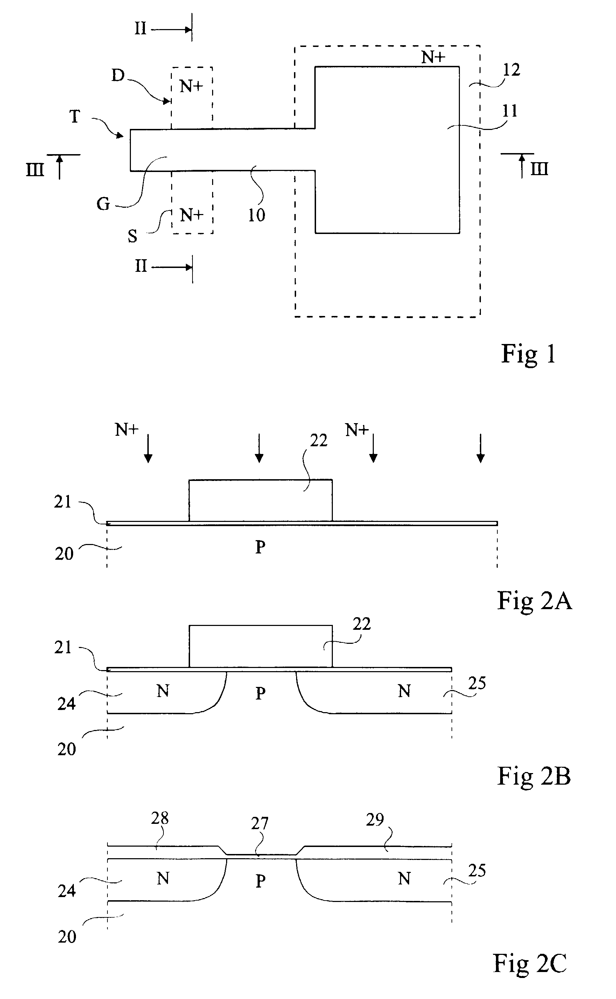

On connaît des points mémoire à grille flottante dans lesquels la grille de commande est constituée d'une couche diffusée dans un substrat de silicium. On peut ainsi former des points mémoire à grille flottante à un seul niveau de silicium polycristallin. Un exemple d'un tel point mémoire est représenté en figure 1. Un transistor MOS T comprend une région de drain D et une région de source S de type N⁺ formées dans un substrat de silicium de type P de part et d'autre d'une grille G constituée d'une portion d'une région de silicium polycristallin 10. Par ailleurs, la région de silicium polycristallin 10 s'étend sur une région 11 où elle est disposée au-dessus d'une région 12 de type N⁺ formée dans le substrat. Bien entendu, quand on mentionne un substrat de silicium de type P, il pourra s'agir d'un substrat proprement dit, ou d'une couche épitaxiée sur un substrat de silicium, ou encore d'un caisson de type P formé dans un substrat. Par souci de simplification, on n'a pas représenté en figure 1 les diverses connexions. Il est clair qu'il faudra prévoir une borne de drain reliée à la région D, une borne de source reliée à la région S et une borne de commande reliée à la région 12. De telles structures sont bien connues dans la technique et ne seront pas décrites plus en détail ici. On comprendra que la région de silicium polycristallin 10 constitue une grille flottante du transistor T, cette grille flottante étant couplée capacitivement avec une grille de commande 12. On s'intéressera essentiellement au procédé de fabrication utilisé.

De façon classique, on réalise d'abord dans le substrat P la région de type N⁺ 12, éventuellement en même temps que d'autres régions du circuit intégré dans lequel est formée la structure considérée. Ensuite, après avoir formé en divers emplacements des oxydes de silicium d'épaisseurs appropriées, on dépose et on grave la région de silicium polycristallin 10 pour constituer d'une part la région 11 couplée capacitivement avec la grille de commande 12, et d'autre part la grille G du transistor MOS T. Après quoi, on forme en se servant notamment de la grille comme masque les régions de drain et de source du transistor. De façon classique, ces régions sont formées en une ou plusieurs étapes avec ou sans utilisation d'espaceurs. On notera, notamment pour des mémoires dites flash, que l'oxyde de grille sous la portion de grille G est un oxyde tunnel de faible épaisseur et que les régions de drain et de source s'étendent partiellement au moins sous la grille.

Ces divers procédés ont été optimisés essentiellement pour favoriser la constitution de points mémoire dont on veut former un grand nombre dans une même puce. Toutefois, un inconvénient de ces procédés est de nécessiter un grand nombre d'étapes de fabrication, notamment quand les régions de source et de drain sont formées à partir de plusieurs implantations successives.

Ainsi, un objet de la présente invention est de prévoir un procédé simple de fabrication d'un point mémoire à grille flottante et à un seul niveau de silicium polycristallin plus particulièrement réalisable en utilisant seulement les étapes classiquement prévues pour la fabrication d'un circuit intégré de type CMOS ou de type BICMOS.

Pour atteindre ces objets ainsi que d'autres, la présente invention prévoit un procédé de fabrication d'un transistor MOS, comprenant les étapes consistant à délimiter au moyen d'un premier masque de résine des zones d'implantation de drain et de source de type N ; éliminer le premier masque et faire diffuser le dopant implanté ; recuire, d'où il résulte qu'il se forme un oxyde plus épais au-dessus des régions de source et de drain qu'au-dessus de la partie centrale d'isolement de grille ; former un doigt de silicium polycristallin au-dessus de la partie centrale d'isolement de grille de façon à constituer la grille du transistor MOS ; et procéder à une deuxième implantation de source/drain.

Selon un mode de réalisation de la présente invention, une deuxième implantation de source/drain est précédée de la formation d'espaceurs.

Selon un mode de réalisation de la présente invention, le doigt de grille est prolongé d'une région de silicium polycristallin constituant un couplage capacitif avec une région dopée formée dans le substrat en même temps que la première implantation de dopant de type N.

La présente invention prévoit un tel procédé compatible avec la réalisation d'une structure de type BICMOS, dans lequel l'implantation initiale de source/drain et l'implantation de la région à couplage capacitif sont réalisées en même temps que les implantations de puits collecteur des transistors bipolaires NPN.

Selon un mode de réalisation de la présente invention, le transistor est formé dans un caisson complètement isolé par des régions du type de conductivité opposé.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente une vue de dessus d'une structure de point mémoire à grille flottante à un seul niveau de silicium polycristallin que la présente invention vise à réaliser par un nouveau procédé ;
les figures 2A à 2E sont des vues en coupe selon la ligne II-II de la figure 1 illustrant des étapes successives de fabrication selon la présente invention ; et
la figure 3 est une vue en coupe selon la ligne III-III de la structure de la figure 1 obtenue par le procédé selon la présente invention.

A l'étape illustrée en figure 2A, on forme sur un substrat 20 de silicium monocristallin de type P, au-dessus d'une couche mince d'oxyde 21, un masque de résine photosensible 22 ayant sensiblement la forme de la grille à fabriquer et on implante à forte concentration un dopant de type N, qui correspond par exemple au dopant utilisé dans les circuits BICMOS pour reprendre des contacts avec une couche enterrée de collecteur de type N, cette implantation étant couramment appelée implantation de puits collecteur ou diffusion "Nsinker". Lors de cette étape d'implantation, on implante de préférence aussi la région 12 illustrée en figure 1.

A l'étape illustrée en figure 2B, on a procédé à un recuit pour faire diffuser le dopant implanté et fournir des régions de type N 24 et 25 qui constitueront comme on le verra ci-après des éléments de régions de drain et de source. L'implantation Nsinker étant une implantation destinée à fournir une diffusion profonde, pour rejoindre des couches enterrées de type N⁺, les zones diffusées 24 et 25 s'étendront assez largement sous l'emplacement du masque de résine 22.

A l'étape illustrée en figure 2C, on a procédé à un nettoyage de l'oxyde 21 puis à une nouvelle étape d'oxydation thermique, d'où il résulte qu'il se forme une couche d'oxyde sur la surface du substrat, cette couche étant plus épaisse sur les régions fortement dopées de type N qu'au-dessus de la région de substrat faiblement dopée de type P. On obtient donc sur le substrat, entre les régions 24 et 25, une couche d'oxyde mince 27 ayant une épaisseur désirée pour constituer un oxyde tunnel et de part et d'autre de cette région 27 des régions d'oxyde plus épaisses 28 et 29 respectivement au-dessus des régions 24 et 25.

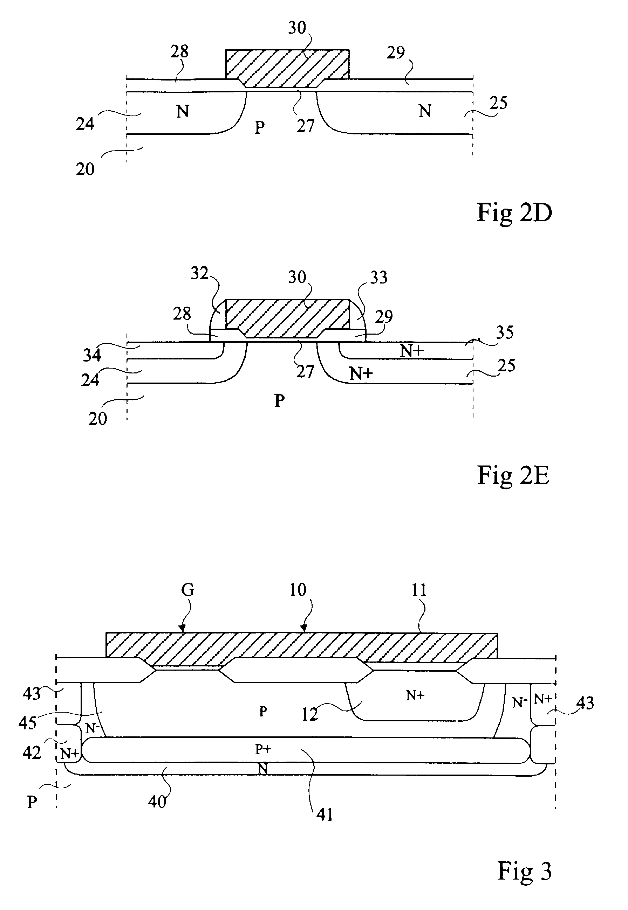

A l'étape illustrée en figure 2D, on dépose et on grave un doigt de silicium polycristallin 30 de façon qu'il recouvre de façon certaine toute la région d'oxyde mince 27 et qu'il s'étende légèrement au-delà de cette région. Le doigt de silicium polycristallin 30 n'est pas auto-aligné avec le masque 22. Pour bien illustrer ce fait, on a représenté de façon exagérée en figure 2D le doigt de silicium polycristallin 30 s'étendant plus largement du côté droit de la figure que du côté gauche de la figure par rapport à la région 27.

En figure 2E, on a représenté la structure après formation d'espaceurs, par exemple des espaceurs d'oxyde 32 et 33, de part et d'autre du doigt de silicium polycristallin 30. Les parties d'oxyde de silicium 28 et 29 sont éliminées en dehors de la zone délimitée par les espaceurs. Après quoi, on réalise une nouvelle implantation de dopant de type N à fort niveau de dopage et l'on procède à un recuit. On obtient ainsi des régions de type N fortement dopées 34 et 35 à la surface des régions de source et de drain à l'intérieur des régions de type N préalablement formées 24 et 25. Les implantations 34 et 35 sont de préférence réalisées en même temps que les implantations de dopant de source et de drain des autres transistors MOS du circuit CMOS dans lequel est réalisé le point mémoire selon l'invention.

Pendant le recuit des régions 34 et 35, les régions 24 et 25 diffusent à nouveau. La limite interne de ces régions s'étend donc partiellement sous la couche d'oxyde mince 27.

On a donc ainsi obtenu une structure de point mémoire de type flash EEPROM, à condition bien entendu d'avoir formé simultanément les autres éléments de la structure représentés en figure 1.

Dans un mode de réalisation de la présente invention :
- le doigt de résine 30 a une largeur de 1,8 µm,
- la région d'oxyde mince 27 a une largeur de 0,6 µm,
- la distance entre les zones N⁺ 24 et 25 est d'environ 0,3 µm
- le doigt de silicium polycristallin 30 a une largeur de 0,8 µm,
- l'oxyde 27 a une épaisseur de l'ordre de 12 nm,
- les couches d'oxyde 28 et 29 ont une épaisseur d'environ 24 nm.

Bien entendu, les autres étapes courantes de réalisation d'un transistor MOS dans un circuit intégré MOS ou BICMOS, telles que des étapes de siliciuration et de prise de contact, seront réalisées de façon classique.

La figure 3 représente une vue en coupe selon la ligne III-III d'un dispositif achevé selon la présente invention. On a représenté la structure dans le cadre d'un procédé de fabrication de type BICMOS dans lequel on a formé sur un substrat P des couches enterrées successives, par exemple une couche d'isolement de type N 40, une couche enterrée de type P⁺ 41, et une couche enterrée de type N⁺ 42. Des régions de diffusion profonde d'isolement de caisson de type N⁺ 43 servent à délimiter une structure. Le dispositif selon la présente invention est formé dans un caisson de type P 45 lui-même formé dans une portion d'une couche épitaxiée de type N 46. Ainsi le caisson P contenant un ou plusieurs points mémoire est complètement isolé. Dans la vue en coupe de la figure 3, on voit à la partie supérieure la couche de silicium polycristallin 10 comprenant dans sa partie de gauche la région de grille G et dans sa partie de droite la région 11 en couplage capacitif avec une région de type N⁺ 12 correspondant à la grille de commande, cette région 12 étant formée en même temps que les régions 24 et 25 décrites précédemment.

On notera que, selon la présente invention, bien que des régions de source et de drain soient formées avant la région de grille correspondante, on obtient quand même un auto-alignement entre l'oxyde de grille tunnel 27 et les régions de source et de drain 24 et 25 et qu'un éventuel décentrage dû à un défaut d'alignement du doigt de grille 30 a peu de conséquences pratiques.

Avec les exemples numériques donnés précédemment, la programmation se fera par injection d'électrons chauds côté drain en appliquant une tension de drain de l'ordre de 5 V et une tension de grille de l'ordre de 12 V. L'effacement s'obtiendra par effet tunnel Fowler Nordheim en appliquant une tension de source de l'ordre de 10 V et une tension de grille sensiblement nulle, le drain étant en l'air.

La présente invention est susceptible de diverses variantes et modifications qui apparaîtront à l'homme de l'art. Notamment, la formation des espaceurs d'oxyde 32 et 33 pourra être omise ou remplacée par une étape équivalente utilisée dans la technologie MOS considérée. On pourra également prévoir des étapes de siliciuration, par exemple une siliciuration simultanée de la grille et des drains et sources.

## Revendications

1. Procédé de fabrication d'un transistor MOS, caractérisé en ce qu'il comprend les étapes suivantes :
délimiter au moyen d'un premier masque de résine (22) des zones d'implantation de drain (24) et de source (25) de type N ;
éliminer le premier masque et faire diffuser le dopant implanté ;
recuire, d'où il résulte qu'il se forme un oxyde plus épais (28, 29) au-dessus des régions de source et de drain qu'au-dessus de la partie centrale d'isolement de grille (27) ;
former un doigt de silicium polycristallin au-dessus de la partie centrale d'isolement de grille (27) de façon à constituer la grille (30) du transistor MOS ; et
procéder à une deuxième implantation de source/drain (34, 35).

2. Procédé selon la revendication 1, caractérisé en ce qu'une deuxième implantation de source/drain (34, 35) est précédée de la formation d'espaceurs (32, 33).

3. Procédé selon la revendication 1, caractérisé en ce que le doigt de grille (30) est prolongé d'une région de silicium polycristallin (11) constituant un couplage capacitif avec une région dopée (12) formée dans le substrat en même temps que la première implantation de dopant de type N (24, 25).

4. Procédé selon la revendication 3, compatible avec la réalisation d'une structure de type BICMOS, caractérisé en ce que l'implantation initiale de source/drain (24, 25) et l'implantation de la région à couplage capacitif (12) sont réalisées en même temps que les implantations de puits collecteur des transistors bipolaires NPN.

5. Procédé selon la revendication 4, caractérisé en ce que le transistor est formé dans un caisson (45) complètement isolé par des régions du type de conductivité opposé.
